# FASCICULE DE BREVET EUROPEEN

(11) **EP 2 080 269 B1**
(45) Date de publication et mention de la délivrance du brevet: **18.08.2010**
(21) Numéro de dépôt: 07820882.4
(22) Date de dépôt: 03.10.2007
(51) Int. Cl.: H03L 7/197

(54) **SYNTHETISEUR DE FREQUENCE A LARGE BANDE A SUPPRESSION D'EMISSIONS PARASITES BASSES FREQUENCES**
BREITBANDFREQUENZ-SYNTHESIZER MIT ELIMINIERUNG VON PARASITÄREN NIEDERFREQUENZEMISSIONEN
BROADBAND FREQUENCY SYNTHESIZER WITH ELIMINATION OF LOW-FREQUENCY PARASITIC EMISSIONS

(30) Priorité: 16.10.2006 EP 06122367
(43) Date de publication de la demande: 22.07.2009
(73) Titulaire: The Swatch Group Research and Development Ltd., 2074 Marin (CH)
(72) Inventeur: CASAGRANDE, Arnaud, 2014 Bôle (CH)
(74) Mandataire: Ravenel, Thierry Gérard Louis
(86) Numéro de dépôt international: PCT/EP2007/060505
(87) Numéro de publication internationale: WO 2008/046741

(56) Documents cités:
- CA-A1- 2 267 496
- JP-A- 2005 033 581
- US-A1- 2003 109 237

## Description

L'invention concerne un synthétiseur de fréquence à large bande capable de supprimer des émissions ou composantes basses fréquences principalement pour une fréquence d'un signal de sortie proche du centre de bande de fréquences du synthétiseur. Le synthétiseur à boucle à blocage de phase comprend un oscillateur commandé en tension pour fournir au moins un signal à haute fréquence de sortie. La fréquence de ce signal à haute fréquence est divisée dans un circuit diviseur double mode par un premier facteur de division N1 dans un premier mode sélectionné ou par un second facteur de division N2 différent du premier facteur N1 dans un second mode sélectionné. Un détecteur de phase du synthétiseur compare un signal à fréquence de référence avec un signal à fréquence divisée fourni par le circuit diviseur. Le détecteur de phase est suivi par un filtre passe-bas pour filtrer le signal de sortie du détecteur de phase pour fournir un signal filtré de commande à l'oscillateur commandé en tension. Un moyen de sélection de mode de division commande le circuit diviseur pour sélectionner par période de temps déterminée le premier mode ou le second mode de division du circuit diviseur. Ce moyen de sélection de mode permet de définir une moyenne des premier et second modes de division dans le temps en fonction de la fréquence programmée du signal de sortie de l'oscillateur commandé en tension.

Les synthétiseurs de fréquence peuvent être utilisés notamment dans des systèmes de communication sans fil ou, plus généralement, dans des systèmes de télécommunication. Ces synthétiseurs de fréquence fournissent des signaux à haute fréquence dans une bande de fréquences déterminée de manière à couvrir une bande de télécommunication, telle que la bande ISM américaine (902 à 928 MHz) par exemple. Pour obtenir la fréquence de sortie désirée en sortie de l'oscillateur commandé en tension, une succession de modes sélectionnés dans le circuit diviseur selon un ordre déterminé est commandée par un signal binaire de sélection fourni par le moyen de sélection de mode. Dans un premier mode M1 égal à 0, il est effectué une division de la fréquence du signal de sortie de l'oscillateur commandé en tension par un premier facteur de division du circuit diviseur, alors que dans un second mode M2 égal à 1, il est effectué une division par un second facteur de division du circuit diviseur.

Lorsqu'il est choisi de sélectionner une fréquence du signal de sortie du synthétiseur située proche du centre de bande de fréquences, on rencontre généralement des problèmes liés à des émissions ou des composantes parasites basses fréquences. Ces émissions parasites peuvent perturber le signal de sortie du synthétiseur. Il en est de même pour une fréquence choisie aux limites basse et haute de la bande de fréquences du synthétiseur, mais généralement le synthétiseur est prévu pour avoir une largeur de bande de fréquences plus grande que la bande de fréquences de communication. De ce fait, les problèmes d'émissions parasites concernent essentiellement le centre de bande.

Les problèmes d'émissions parasites basses fréquences proviennent principalement dans la succession de modes dans le temps opérée par le moyen de sélection programmée de modes, qui peut être de préférence un modulateur du type sigma-delta. Un tel modulateur du type sigma-delta permet de définir une succession de modes selon une configuration pseudo-aléatoire dans un signal binaire de sélection commandant le circuit diviseur. Cette succession de mode égal à 0 et de mode égal 1 est dépendante d'un signal de programmation reçu de la fréquence choisie du signal de sortie de l'oscillateur commandé en tension.

Pour un tel modulateur sigma-delta normalement la variation de mode égal à 1 et de mode égal à 0 dans la succession de modes est à une fréquence plus grande que la fréquence de coupure du filtre passe-bas. Ceci permet de repousser le bruit vers les hautes fréquences, ce qui est filtré. Cependant pour une fréquence programmée du signal de sortie proche du centre de bande, le nombre de mode égal à 0 est sensiblement égal au nombre de mode égal à 1. En fonction de la périodicité de 0 et de 1 dans la succession de modes du signal binaire, il peut survenir parfois soit un 1 à la place d'un 0, soit un 0 à la place d'un 1. Ceci se traduit par une basse fréquence à chaque occurrence de 1 ou 0 dans la succession de modes dans le temps. Ces rares occurrences de 1 ou de 0 dans la succession de modes du signal binaire ne sont donc pas filtrées par le filtre passe-bas, ce qui perturbe l'oscillateur commandé en tension.

Ces problèmes d'émissions parasites basses fréquences sont les mêmes pour une fréquence du signal de sortie choisie à la limite basse ou haute de la bande de fréquences. Dans ce cas, il peut survenir rarement un 1 parmi tous les 0 de la succession de mode pour une fréquence à la limite basse de la bande de fréquences, ou rarement un 0 parmi tous les 1 pour une fréquence à la limite haute de la bande de fréquences. Cependant comme la bande de fréquences déterminée du synthétiseur de fréquence est généralement plus large que la bande de fréquences de télécommunication, il n'est jamais programmé une fréquence proche des limites basse et haute de la bande de fréquences. De ce fait, le problème principal d'émissions parasites est relatif à une programmation d'une fréquence de l'oscillateur commandé en tension proche du centre de bande de fréquences.

Il est connu pour essayer de réduire les problèmes liés aux composantes parasites basses fréquences d'injecter du bruit aléatoire dans la boucle à blocage de phase du type sigma-delta. Cependant, cette pratique a le désavantage de ne supprimer que partiellement ces composantes parasites, et présente également le désavantage d'ajouter du bruit large bande au signal utile du synthétiseur de fréquence.

On connaît par la demande de brevet US 2003/0227301, un synthétiseur de fréquence à réduction du bruit. Ce synthétiseur de fréquences est basé sur une boucle à blocage de phase traditionnelle (PLL), ainsi que l'utilisation d'un modulateur sigma-delta, qui permet de sélectionner le rapport de division d'un diviseur multi-mode. Un but de ce synthétiseur est de résoudre le problème des bandes mortes, quand le facteur de division est sélectionné égal à N ou à N+1. Ce synthétiseur comprend donc un premier bloc diviseur pour diviser la fréquence de référence d'un oscillateur, un second bloc diviseur pour diviser d'un facteur sélectionné la fréquence des signaux à haute fréquence d'un oscillateur commandé en tension, et un contrôleur du rapport de division ayant un modulateur sigma-delta. Le second bloc diviseur permet de diviser la fréquence des signaux à haute fréquence par un premier facteur N ou par un second facteur N+1 ou par un troisième facteur N+2. La sélection du facteur de division est opérée en fonction d'un signal de sélection fourni par le modulateur sigma-delta combiné avec un contrôleur de mode. Grâce à une succession de modes dans le temps entre les trois facteurs de division sélectionnables, il est possible de réduire le bruit de quantification.

Par contre, il n'est pas imaginé de configurer ce synthétiseur de fréquence pour supprimer les émissions ou composantes parasites pour une fréquence programmée d'un signal de sortie proche du centre de bande de fréquences du synthétiseur. De plus, il est opéré une commutation de modes dans le temps utilisant en continu trois facteurs de division du second bloc diviseur, qui est donc commandé par des signaux de sélection à 2 bits, ce qui est fort consommateur en énergie électrique, et relativement compliqué à mettre en oeuvre.

Dans la demande de brevet US 200310109237, il est décrit un synthétiseur de fréquence N-fractionnel. Ce synthétiseur comprend un modulateur sigma delta combiné avec un ensemble à diviseurs de fréquence dans le chemin retour de la boucle à blocage de phase. Deux chemins à division de fréquence peuvent être utilisés. Dans le cas où le facteur de division à l'intérieur d'une gamme de valeurs fractionnelles, est assez loin d'une valeur entière (entre 0.03 et 0.97), le premier chemin de fréquence dans la boucle retour est utilisé. Par contre dans le cas où le facteur de division est proche d'une valeur entière (plus petit que 0.03 et plus grand que 0.97), c'est-à-dire proche des limites basse ou haute de la bande de fréquences, ce qui peut produire des erreurs, il est utilisé le second chemin de fréquence dans la boucle retour. Cependant il n'est pas opéré un changement de facteurs de division, lorsque la fréquence se trouve proche du centre de la bande de fréquences, ce qui est un inconvénient.

L'invention a donc pour objet de fournir un synthétiseur de fréquence à large bande susceptible de supprimer facilement des émissions basses fréquences principalement pour une fréquence du signal de sortie de l'oscillateur commandé en tension proche du centre de bande de fréquences tout en palliant les inconvénients de l'état de la technique cité ci-dessus.

A cet effet, l'invention concerne un synthétiseur de fréquence à large bande cité ci-devant qui comprend les caractéristiques définies dans la revendication 1.

Des formes d'exécution avantageuses du synthétiseur de fréquence définies dans les revendications dépendantes 2 à 7.

Un avantage du synthétiseur de fréquence selon l'invention réside dans le fait qu'il permet de supprimer les émissions ou composantes parasites basses fréquences pour toute fréquence choisie dans la bande de fréquence du synthétiseur avec un circuit diviseur fonctionnant toujours en double mode. Un couple de facteurs de division est toujours utilisé dans la boucle à blocage de phase par rapport à un synthétiseur de fréquence qui utilise en continu trois facteurs de division comme dans la demande de brevet US 2003/0227301. Une économie de consommation électrique du synthétiseur est ainsi réalisée, et la réalisation d'un tel synthétiseur est fortement simplifiée.

Si la fréquence programmée se situe dans une zone intermédiaire entre la limite basse ou la limite haute et le centre de bande de fréquences, le circuit diviseur permet de diviser la fréquence du signal de sortie par un premier facteur N1 dans un premier mode sélectionné ou par un second facteur N2 dans un second mode sélectionné. La valeur différente des premier et second facteurs de division N1 et N2 permet de définir la bande de fréquences déterminée du synthétiseur.

Par contre si la fréquence programmée se situe proche du centre de la bande de fréquences déterminée, par exemple dans une marge de ± 5% autour du centre de bande, le circuit diviseur double mode est configuré pour diviser la fréquence du signal de sortie par un troisième facteur N3 dans un premier mode sélectionné ou par un quatrième facteur N4 dans un second mode sélectionné par le moyen de sélection de modes. Normalement soit le troisième facteur N3, soit le quatrième facteur N4 a une valeur différente du premier facteur N1 ou du second facteur N2. Avec cela pour une fréquence programmée proche du centre de bande déterminée, cela permet de décaler le centre de bande sur la base des troisième et quatrième facteurs de division, et ainsi supprimer les composantes parasites basses fréquences.

Avantageusement, le circuit diviseur comprend un premier bloc diviseur pour diviser la fréquence du signal de sortie par le premier facteur ou par le second facteur de division selon le mode sélectionné, et un second bloc diviseur pour diviser la fréquence du signal de sortie par le troisième facteur ou par le quatrième facteur de division selon le mode sélectionné. Un élément commutateur du circuit diviseur permet de sélectionner soit le premier bloc diviseur, soit le second bloc diviseur en fonction d'un signal de commande reçu dépendant de la position de la fréquence choisie dans la bande de fréquences.

Avantageusement, le synthétiseur de fréquence permet d'effectuer une synthèse de fréquence du type sigma delta à large bande avec l'aide d'un modulateur du type sigma-delta comme moyen de sélection de modes. Le modulateur du type sigma-delta fournit un signal binaire de sélection (1 bit) au circuit diviseur double mode.

Les buts, avantages et caractéristiques du synthétiseur de fréquence à large bande apparaîtront mieux dans la description suivante d'une forme d'exécution non limitative en regard des dessins sur lesquels :
- la figure 1 représente de manière simplifiée les différents éléments, qui composent le synthétiseur de fréquence à large bande selon l'invention, et
- la figure 2 représente de manière simplifiée un graphique du spectre des signaux utiles et parasites à filtrer en amont du filtre passe-bas du synthétiseur de fréquence avec le problème des émissions parasites basses fréquences selon la fréquence programmée du signal de sortie de l'oscillateur commandé en tension.

Dans la description suivante, tous les éléments du synthétiseur de fréquence à large bande qui sont bien connus de l'homme du métier dans ce domaine technique ne sont relatés que de manière simplifiée.

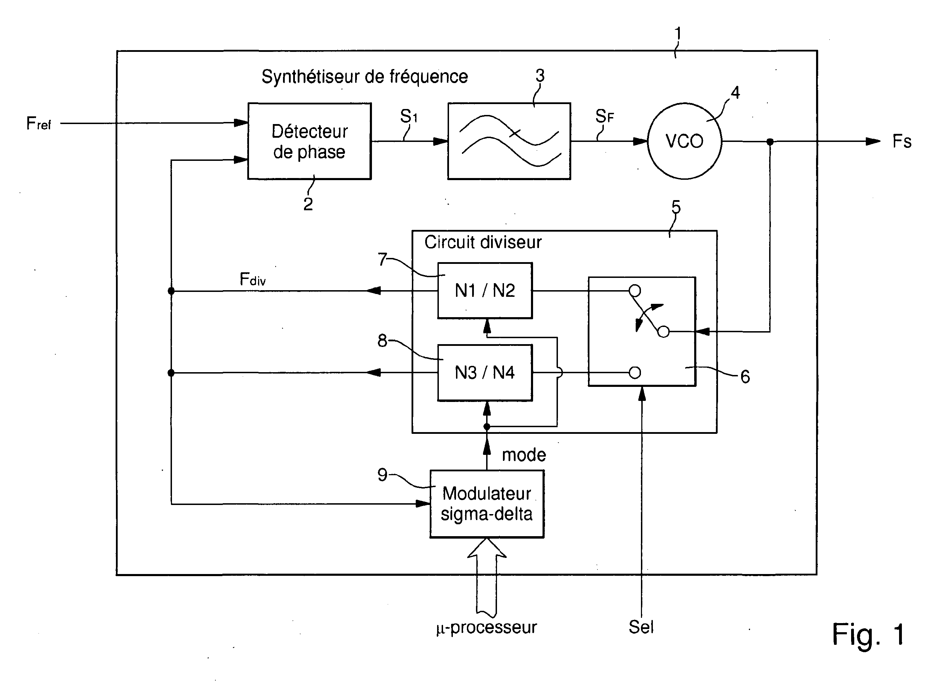

La figure 1 illustre schématiquement tous les éléments d'une forme d'exécution d'un synthétiseur de fréquence à large bande 1 qui peut être utilisé dans un système de télécommunication. Ce synthétiseur de fréquence 1 comprend dans une boucle à blocage de phase, un détecteur de phase 2, un filtre passe-bas 3, un oscillateur commandé en tension (VCO) 4, et un circuit diviseur double mode 5 commandé par un moyen de sélection de modes 9. Le détecteur de phase 2 compare un signal de référence F_{ref} à fréquence stable, par exemple 13 MHz, fourni par un oscillateur conventionnel de référence non représenté, avec un signal à fréquence divisée F_{div} fourni par le circuit diviseur 5. Le signal de sortie du détecteur S₁ est filtré par le filtre passe-bas 3, qui a de préférence une fréquence de coupure à 100 kHz, afin de fournir un signal filtré de commande S_{F} à l'oscillateur commandé en tension 4. Sur la base de ce signal de commande S_{F}, l'oscillateur commandé en tension 4 produit un signal de sortie à haute fréquence F_{S}, dont la fréquence est comprise dans une bande de fréquence déterminée du synthétiseur.

Le circuit diviseur double mode 5 comprend principalement un premier bloc diviseur double mode 7. Ce premier bloc diviseur peut être composé de manière connue d'un ou plusieurs diviseurs par 2 ou par 3 du type synchrone et/ou asynchrone. Ce premier bloc diviseur permet de diviser la fréquence du signal de sortie à haute fréquence F_{S} de l'oscillateur commandé en tension 4, par un premier facteur N1 dans un premier mode sélectionné M1 ou par un second facteur N2 différent du premier facteur N1 dans un second mode sélectionné M2. La valeur du premier facteur N1 est égale à N, qui est de préférence un nombre entier supérieur ou égal à 2, et la valeur du second facteur N2 est égale à N+M où M est un nombre entier supérieur ou égal à 1, par exemple égal à 3.

Les premier et second facteurs de division N1 et N2 permettent de définir dans la boucle à blocage de phase une bande de fréquences déterminée du synthétiseur de fréquence pour couvrir la bande de fréquences de communication souhaitée. Avec un premier facteur N1 par exemple égal à 69 (N) et un second facteur N2 par exemple égal à 72 (N+M), cela permet de définir une bande de fréquences de 897 à 936 MHz avec un signal de référence F_{ref} à fréquence égale à 13 MHz. Un tel synthétiseur 1 est susceptible d'être utilisé pour une synthèse de fréquence par exemple dans la bande ISM américaine de 902 à 928 MHz.

La fréquence choisie dans la bande de fréquences du signal de sortie Fₛ de l'oscillateur commandé en tension 4 est obtenue sur la base d'un signal de programmation du moyen de sélection de modes 9 du circuit diviseur double mode 5. Ce signal de programmation, qui peut être un mot binaire de programmation, est fourni par un microprocesseur traditionnel non représenté. Le moyen de sélection programmée de modes du circuit diviseur 5 sélectionne par période de temps déterminée le premier mode M1 ou le second mode M2 de division du circuit diviseur. Ceci permet de définir une moyenne des premier M1 et second M2 modes de division dans le temps du synthétiseur ou une moyenne principalement des premier N1 et second N2 facteurs de division. Cette moyenne est fonction de la fréquence programmée Fₛ du signal de sortie de l'oscillateur commandé en tension 4 dans la bande de fréquences déterminée.

Le moyen de sélection de modes 9 est de préférence un modulateur sigma-delta traditionnel, qui permet normalement de repousser le bruit généré dans la boucle à blocage de phase vers les hautes fréquences, ce qui est filtré par le filtre passe-bas 3. Ce modulateur sigma-delta permet de fournir un signal de sélection constitué d'une succession de 0 et de 1 correspondant respectivement au premier M1 et second M2 modes sélectionnés du circuit diviseur 5. Cette succession de 0 et de 1 est obtenue selon une configuration pseudo-aléatoire par un cadencement fourni par le signal à fréquence divisée F_{div} du circuit diviseur. Ainsi comme indiqué ci-dessus, en fonction du nombre de 1 par rapport au nombre de 0 dans le signal de sélection (mode), cela permet de déterminer une moyenne de modes dans le temps. Cette moyenne permet donc de définir un signal de commande filtré de l'oscillateur commandé en tension 4, afin qu'il produise précisément la fréquence Fₛ souhaitée.

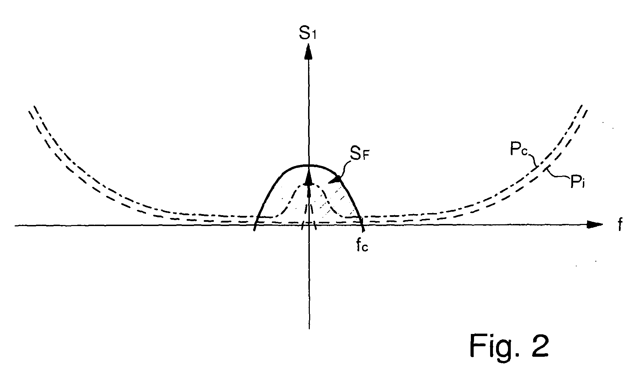

Si la fréquence choisie Fₛ se trouve dans une zone intermédiaire de la bande de fréquences, c'est-à-dire entre la limite basse ou la limite haute et le centre de bande, le circuit diviseur double mode 5 opère une division de fréquence à l'aide du premier bloc diviseur double mode 7. Par contre, si cette fréquence se situe proche du centre de bande, par exemple dans une marge de ± 5% de 916.5 MHz dans une bande de fréquences de 897 à 936 MHz, le spectre de fréquence en amont du filtre passe-bas est chargé de composantes parasites basses fréquences. Ces composantes basses fréquences ne peuvent pas être filtrées par ledit filtre passe-bas 3, comme indiqué ci-après en référence à la figure 2. De ce fait, cela perturbe le signal de commande S_{F} de l'oscillateur commandé en tension, qui ne présente ainsi plus une fréquence bien définie, telle qu'un Dirac dans le spectre de fréquences, du signal de sortie à haute fréquence.

Il est à noter que les problèmes des composantes parasites basses fréquences proviennent principalement dans la succession de modes dans le temps opérée par le modulateur du type sigma-delta comme expliqué ci-dessus. Normalement la variation de mode égal à 1 et de mode égal à 0 dans le signal de sélection de modes est à une fréquence plus grande que la fréquence de coupure du filtre passe-bas (100 kHz). Cependant pour une fréquence programmée du signal de sortie proche du centre de bande, le nombre de mode égal à 0 est sensiblement égal au nombre de mode égal à 1. Il peut survenir parfois soit un 1 à la place d'un 0, soit un 0 à la place d'un 1. Ceci se traduit par une basse fréquence à chaque occurrence de 1 ou 0 dans la succession de modes dans le temps. Ces rares occurrences de 1 ou de 0 dans la succession de modes du signal de sélection binaire ne sont donc pas filtrées par le filtre passe-bas, ce qui perturbe l'oscillateur commandé en tension:

Pour supprimer les émissions ou composantes parasites basses fréquences pour une fréquence du signal de sortie proche du centre de bande, le circuit diviseur 5 comprend un second bloc diviseur double mode 8. Ce second bloc diviseur 8 est mis en fonction en lieu et place du premier diviseur double mode 7, quand il est détecté qu'une fréquence programmée du synthétiseur se situe proche du centre de la bande de fréquences. Ce second bloc diviseur 8 en fonction permet de diviser la fréquence du signal de sortie Fₛ par un troisième facteur de division N3 dans le premier mode sélectionné M1 ou par un quatrième facteur de division N4 différent du troisième facteur N3 dans le second mode sélectionné M2. Au moins le troisième facteur de division N3 ou le quatrième facteur de division N4 sont différents des premier et/ou second facteurs de division N 1 et N2. La valeur du troisième facteur N3 peut être égale à N comme la valeur du premier facteur N1, alors que la valeur du quatrième facteur N4 peut être égale à N+M+1. Cependant, la valeur du troisième facteur N3 peut aussi être égale à N+1, alors que la valeur du quatrième facteur N4 peut être égale à N+M comme le second facteur N2.

Les troisième et quatrième facteurs de division N3 et N4 permettent de définir une autre bande de fréquences dans laquelle se trouve la fréquence désirée du signal de sortie Fₛ. Le centre de cette autre bande de fréquences (par exemple 923 MHz) est ainsi décalé du centre de bande de fréquences (par exemple 916.5 MHz) définie par les premier et second facteurs de division N1 et N2. De cette manière, cela permet de situer la fréquence programmée dans une des deux parties intermédiaires de l'autre bande de fréquences, ce qui supprime lesdites composantes parasites. Les troisième et quatrième facteurs N3 et N4 peuvent être respectivement égal à 70 et égal à 72, par rapport aux premier et second facteurs N 1 et N2 respectivement égal à 69 et égal à 72.

En fonction de la position de la fréquence choisie du signal de sortie Fₛ dans la bande de fréquences du synthétiseur de fréquence 1, le circuit diviseur double mode 5 comprend encore un élément commutateur 6 pour la sélection du premier bloc diviseur 7 ou du second bloc diviseur 8. Dans la forme d'exécution présentée à la figure 1, cet élément commutateur 6 est disposé à l'entrée du circuit diviseur pour recevoir le signal de sortie à haute fréquence Fₛ. Cet élément commutateur 6 est commandé par un signal de commande Sel, qui est fonction de la position de la fréquence choisie dans la bande de fréquences déterminée. Pour une fréquence située dans une des parties intermédiaires de la bande de fréquence, l'élément commutateur 6 fournit le signal de sortie à diviser uniquement au premier bloc diviseur 7. Par contre pour une fréquence voisine du centre de la bande de fréquences, l'élément commutateur 6 fournit le signal de sortie à diviser uniquement au second bloc diviseur 8.

Il est à noter qu'il peut être imaginé de placer un élément commutateur 6 entre une borne d'alimentation électrique d'une source de tension et une borne d'alimentation électrique correspondante de chaque bloc diviseur 7, 8. Cet élément commutateur peut être par exemple formé par un multiplexeur traditionnel. Dans ce cas, chaque bloc diviseur reçoit directement le signal de sortie Fₛ de l'oscillateur commandé en tension 4. Pour la sélection de l'un ou l'autre bloc diviseur, l'élément commutateur 6 est destiné à fournir l'alimentation électrique soit au premier bloc diviseur, soit au second bloc diviseur sur la base du signal de commande Sel.

Pour illustrer de manière simplifiée les problèmes liés aux émissions parasites basses fréquences, il est fait référence à la figure 2 montrant notamment un graphe du spectre des signaux de sortie S₁ du détecteur de phase. La partie hachurée de ce graphe définit les signaux filtrés S_{F} par le filtre passe-bas, qui a une fréquence de coupure f_{c} de l'ordre de 100 kHz. Les signaux utiles à filtrer sont uniquement illustrés par une forme triangulaire en traits interrompus se terminant par une flèche dans la partie hachurée. Par simplification, uniquement l'enveloppe des signaux parasites Pc, Pi est représentée.

Pour une fréquence programmée voisine du centre de la bande de fréquences, les signaux parasites Pc (bruit) comprennent des composantes basses fréquences, qui ne sont pas filtrées par le filtre passe-bas, et qui s'ajoutent aux signaux utiles. La partie haute fréquence de ces signaux parasites générés notamment par le modulateur sigma-delta est filtrée par le filtre passe-bas. Par contre, pour une fréquence programmée dans une des zones intermédiaires de la bande de fréquences, les signaux parasites Pi ne comprennent pas de composantes basses fréquences et sont donc bien filtrés par le filtre passe-bas.

Grâce à la sélection du second bloc diviseur double mode du circuit diviseur dans le cas d'une fréquence programmée proche du centre de bande, il est ainsi possible de supprimer les composantes parasites basses fréquences des signaux Pc en générant des signaux parasites à l'image de la courbe Pi.

A partir de la description qui vient d'être faite de multiples variantes de réalisation du circuit synthétiseur de fréquence à large bande peuvent être conçues par l'homme du métier sans sortir du cadre de l'invention définie par les revendications. Le moyen de sélection de modes peut être constitué par un circuit logique à deux compteurs cadencés en synchronisme par un même signal d'horloge, mais le nombre compté par chaque compteur avant une remise à zéro est différent. La sélection du second bloc diviseur du circuit diviseur peut survenir également pour une fréquence choisie du signal de sortie voisine de la limite basse ou de la limite haute de la bande de fréquences du synthétiseur. Il peut être envisagé de réaliser des facteurs de division qui ne sont pas des nombres entiers comme indiqué dans le brevet EP 1 300 950. Le circuit diviseur peut ne comprendre qu'un ensemble de trois facteurs dont uniquement deux facteurs de division sont sélectionnés selon la position de la fréquence choisie dans la bande de fréquences.

## Revendications

1. Synthétiseur de fréquence à large bande (1) comprenant dans une boucle à blocage de phase:
- un oscillateur commandé en tension (4) pour fournir au moins un signal de sortie à haute frequence (Fs) dans une bande de fréquences déterminée,
- un circuit diviseur double mode (5), qui comprend
- un premier bloc diviseur (7) pour diviser la fréquence du signal de sortie par un premier facteur N1 dans un premier mode sélectionnable M1 ou par un second facteur N2 différent du premier facteur N1 dans un second mode sélectionnable M2, afin de fournir un signal à fréquence divisée (Fdjv),
- un second bloc diviseur (8), activé en lieu et place du premier bloc diviseur, lorsque la fréquence du signal de sortie est proche des limites basse ou haute de la bande de fréquences définie par les premier et second facteurs de division N1 et N2, pour diviser la fréquence du signal de sortie par un troisième facteur N3 dans le premier mode sélectionnable M1 ou par un quatrième facteur N4 différent du troisième facteur N3 dans le second mode sélectionnable M2, au moins le troisième facteur de division N3 ou le quatrième facteur de division N4 étant différent respectivement des premier ou second facteurs de division N1 et N2 du premier bloc diviseur (7),
ledit synthétiseur comprenant également:
- un moyen de sélection de mode de division (9) du circuit diviseur pour sélectionner par période de temps déterminée le premier mode M1 ou le second mode M2 de division du circuit diviseur afin de définir une moyenne du facteur de division dans le temps en fonction de la fréquence programmée du signal de sortie,
- un détecteur de phase (2) pour comparer un signal à fréquence de référence (Fref) avec le signal à fréquence divisée fourni par le circuit diviseur,
- un filtre passe-bas (3) pour filtrer le signal de sortie (S1) du détecteur de phase pour fournir un signal filtré (SF) de commande à l'oscillateur commandé en tension,
**caractérisé en ce que**
- le second bloc diviseur (8) est activé en lieu et place du premier bloc diviseur, également lorsque la fréquence du signal de sortie est proche du centre de la bande de fréquences définie par les premier et second facteurs de division N1 et N2.

2. Synthétiseur de fréquence (1) selon la revendication 1, **caractérisé en ce que** le circuit diviseur double mode (5) comprend un élément commutateur (6) pour la sélection du premier bloc diviseur (7) ou du second bloc diviseur (8) sur la base d'un signal de commande reçu (Sel), qui est fonction de la position de la fréquence programmée de l'oscillateur commandé en tension (4) dans la bande de fréquences.

3. Synthétiseur de fréquence (1) selon la revendication 2, **caractérisé en ce que** l'élément commutateur (6) est disposé à l'entrée du circuit diviseur double mode (5) pour recevoir le signal de sortie de l'oscillateur commandé en tension et fournir ce signal de sortie soit au premier bloc diviseur (7), soit au second bloc diviseur (8) sur la base du signal de commande reçu (Sel).

4. Synthétiseur de fréquence (1) selon la revendication 2, **caractérisé en ce que** l'élément commutateur (6) est disposé entre une borne d'alimentation électrique d'une source de tension et une borne d'alimentation électrique correspondante de chaque bloc diviseur recevant le signal de sortie de l'oscillateur commandé en tension (4), pour fournir l'alimentation électrique soit au premier bloc diviseur, soit au second bloc diviseur sur la base du signal de commande reçu (Sel).

5. Synthétiseur de fréquence (1) selon l'une des revendications précédentes, **caractérisé en ce que** le moyen de sélection de mode de division (9) est un modulateur sigma-delta à 1 bit de quantification, qui est cadencé par le signal à fréquence divisée fourni par le circuit diviseur (5).

6. Synthétiseur de fréquence (1) selon l'une des revendications précédentes, **caractérisé en ce que** le premier facteur N1 est égal à N, qui est un nombre entier supérieur ou égal à 2, **en ce que** le second facteur N2 est égal à N+M, où M est un nombre entier supérieur ou égal à 1, **en ce que** le troisième facteur est égal à N, et **en ce que** le quatrième facteur est égal à N+M+1.

7. Synthétiseur de fréquence (1) selon l'une des revendications 1 à 5, **caractérisé en ce que** le premier facteur N 1 est égal à N, qui est un nombre entier supérieur ou égal à 2, de préférence à égal à 69, **en ce que** le second facteur N2 est égal à N+M, de préférence égal à 72, où M est un nombre entier supérieur ou égal à 3, **en ce que** le troisième facteur est égal à N+1, et **en ce que** le quatrième facteur est égal à N+M.

## Claims

1. Broadband frequency synthesizer (1) including in a phase-lock loop:
- a voltage controlled oscillator (4) for providing at least one high frequency output signal (Fₛ) within a determined frequency band,
- a dual mode divider circuit (5), which includes
- a first divider block (7) for dividing the output signal frequency by a first factor N1 in a first selectable mode M1 or by a second factor N2 different from the first factor N1 in a second selectable mode M2 in order to supply a divided frequency signal (F_{div}),
- a second divider block (8), activated in place of the first divider block, when the frequency of the output signal is close to the bottom or top limits of the frequency band defined by the first and second division factors N1 and N2, for dividing the output signal frequency by a third factor N3 in the first selectable mode M1 or by a fourth division factor N4 different from the third factor N3 in the second selectable mode M2, at least the third division factor N3 or the fourth division factor N4 being different respectively from the first or second division factors N1 and N2 of the first divider block (7),
said synthesizer including also :
- a means for selecting the division mode (9) of the divider circuit for selecting by determined time period the first division mode M1 or the second division mode M2 of the divider circuit in order to define a mean of the division factor over time as a function of the programmed frequency of the output signal,
- a phase detector (2) for comparing a reference frequency signal (F_{ref}) to the divided frequency signal provided by the divider circuit,
- a low-pass filter (3) for filtering the output signal (S₁) of the phase detector to provide a filtered control signal (S_{F}) to the voltage controlled oscillator,
**characterized in that**
- the second divider block (8) is activated in place of the first divider block, also when the frequency of the output signal is close to the centre of the frequency band defined by the first and second division factors N1 and N2.

2. Frequency synthesizer (1) according to claim 1, **characterized in that** the dual mode divider circuit (5) includes a switch element (6) for selecting the first divider block (7) or the second divider block (8) on the basis of a received control signal (Sel), which is a function of the position of the programmed frequency of the voltage controlled oscillator (4) in the frequency band.

3. Frequency synthesizer (1) according to claim 2, **characterized in that** the switch element (6) is arranged at the input of the dual mode divider circuit (5) for receiving the output signal from the voltage controlled oscillator and supplying said output signal either to the first divider block (7) or to the second divider block (8) on the basis of the received control signal (Sel).

4. Frequency synthesizer (1) according to claim 2, **characterized in that** the switch element (6) is arranged between an electric supply terminal of a voltage source and a corresponding electric supply terminal of each divider block receiving the output signal from the voltage controlled oscillator (4), for supplying the electric power either to the first divider block, or to the second divider block on the basis of the received control signal (Sel).

5. Frequency synthesizer (1) according to any one of the preceding claims, **characterized in that** the division mode selection means (9) is a sigma-delta modulator with 1 bit of quantification, which is clocked by the divided frequency signal supplied by the divider circuit (5).

6. Frequency synthesizer (1) according to any one of the preceding claims, **characterized in that** the first factor N1 is equal to N, which is an integer number greater than or equal to 2, **in that** the second factor N2 is equal to N+M, where M is an integer number greater than or equal to 1, **in that** the third factor is equal to N, and **in that** the fourth factor is equal to N+M+1.

7. Frequency synthesizer (1) according to any one of claims 1 to 5, **characterized in that** the first factor N1 is equal to N, which is an integer number greater than or equal to 2, preferably equal to 69, **in that** the second factor N2 is equal to N+M, preferably equal to 72, where M is an integer number greater than or equal to 3, **in that** the third factor is equal to N+1, and **in that** the fourth factor is equal to N+M.

## Patentansprüche

1. Breitband-Frequenzsynthetisierer (1), der in einer Phasenverriegelungsschleife umfasst:
- einen spannungsgesteuerten Oszillator (4), um wenigstens ein Hochfrequenz-Ausgangssignal (Fs) in einem bestimmten Frequenzband zu liefern,
- eine Doppelbetriebsart-Teilerschaltung (5), die umfasst:
- einen ersten Teilerblock (7), um die Frequenz des Ausgangssignals in einer ersten auswählbaren Betriebsart M1 durch einen ersten Faktor N1 oder in einer zweiten auswählbaren Betriebsart M2 durch einen von dem ersten Faktor N1 verschiedenen zweiten Faktor N2 zu teilen, um ein Signal (Fdiv) mit geteilter Frequenz zu liefern,
- einen zweiten Teilerblock (8), der statt des ersten Teilerblocks aktiviert wird, wenn die Frequenz des Ausgangssignals nahe bei der unteren oder der oberen Grenze des Frequenzbandes liegt, das durch den ersten und den zweiten Teilungsfaktor N1 bzw. N2 definiert ist, um die Frequenz des Ausgangssignals in der ersten auswählbaren Betriebsart M1 durch einen dritten Faktor N3 oder in der zweiten auswählbaren Betriebsart M2 durch einen von dem dritten Faktor N3 verschiedenen vierten Faktor N4 zu teilen, wobei wenigstens der dritte Teilungsfaktor N3 oder der vierte Teilungsfaktor N4 von dem ersten Teilungsfaktor N1 bzw. von dem zweiten Teilungsfaktor N2 des ersten Teilerblocks (7) verschieden ist,
wobei der Synthetisierer außerdem umfasst:
- ein Mittel zum Auswählen der Teilungsbetriebsart (9) der Teilerschaltung, um pro bestimmter Zeitdauer die erste Teilungsbetriebsart M1 oder die zweite Teilungsbetriebsart M2 der Teilerschaltung zu wählen, um einen zeitlichen Mittelwert des Teilungsfaktors gemäß der programmierten Frequenz des Ausgangssignals zu definieren,
- einen Phasendetektor (2), um ein Signal mit Referenzfrequenz (Fref) mit dem Signal mit geteilter Frequenz, das von der Teilerschaltung geliefert wird, zu vergleichen,
- ein Tiefpassfilter (3), um das Ausgangssignal (S1) des Phasendetektors zu filtern, um ein gefiltertes Steuersignal (SF) für den spannungsgesteuerten Oszillator zu liefern,
**dadurch gekennzeichnet, dass**
- der zweite Teilerblock (8) statt des ersten Teilerblocks auch dann aktiviert wird, wenn die Frequenz des Ausgangssignals in der Nähe der Mitte des Frequenzbandes liegt, das durch den ersten und den zweiten Teilungsfaktor N1 bzw. N2 definiert ist.

2. Frequenzsynthetisierer (1) nach Anspruch 1, **dadurch gekennzeichnet, dass** die Doppelbetriebsart-Teilerschaltung (5) ein Umschaltelement (6) für die Auswahl des ersten Teilerblocks (7) oder des zweiten Teilerblocks (8) auf der Grundlage eines empfangenen Steuersignals (Sel), das eine Funktion der Position der programmierten Frequenz des spannungsgesteuerten Oszillators (4) in dem Frequenzband ist, umfasst.

3. Frequenzsynthetisierer (1) nach Anspruch 2, **dadurch gekennzeichnet, dass** das Umschaltelement (6) am Eingang der Doppelbetriebsart-Teilerschaltung (5) angeordnet ist, um das Ausgangssignal des spannungsgesteuerten Oszillators zu empfangen und um dieses Ausgangssignal auf der Grundlage des empfangenen Steuersignals (Sel) entweder zu dem ersten Teilerblock (7) oder zu dem zweiten Teilerblock (8) zu liefern.

4. Frequenzsynthetisierer (1) nach Anspruch 2, **dadurch gekennzeichnet, dass** das Umschaltelement (6) zwischen einen elektrischen Versorgungsanschluss einer Spannungsquelle und einen entsprechenden elektrischen Versorgungsanschluss jedes Teilerblocks, der das Ausgangssignal des spannungsgesteuerten Oszillators (4) empfängt, geschaltet ist, um die elektrische Versorgung auf der Grundlage des empfangenen Steuersignals (Sel) entweder zu dem ersten Teilerblock oder zu dem zweiten Teilerblock zu liefern.

5. Frequenzsynthetisierer (1) nach einem der vorhergehenden Ansprüche, **dadurch gekennzeichnet, dass** das Mittel (9) für die Wahl der Teilungsbetriebsart ein Sigma-Delta-Modulator mit einer 1-Bit-Quantisierung ist, der durch das von der Teilerschaltung (5) gelieferte Signal mit geteilter Frequenz getaktet wird.

6. Frequenzsynthetisierer (1) nach einem der vorhergehenden Ansprüche, **dadurch gekennzeichnet, dass** der erste Faktor N1 gleich N ist, wobei N eine ganze Zahl größer oder gleich 2 ist, dass der zweite Faktor N2 gleich N + M ist, wobei M eine ganze Zahl größer oder gleich 1 ist, dass der dritte Faktor gleich N ist und dass der vierte Faktor gleich N + M + 1 ist.

7. Frequenzsynthetisierer (1) nach einem der Ansprüche 1 bis 5, **dadurch gekennzeichnet, dass** der erste Faktor N1 gleich N ist, wobei N eine ganze Zahl größer oder gleich 2 und vorzugsweise gleich 69 ist, dass der zweite Faktor N2 gleich N + M und vorzugsweise gleich 72 ist, wobei M eine ganze Zahl größer oder gleich 3 ist, dass der dritte Faktor gleich N + 1 ist und dass der vierte Faktor gleich N + M ist.
